# EUROPÄISCHE PATENTANMELDUNG

(11) **EP 1 439 742 A1**
(43) Veröffentlichungstag der Anmeldung: **21.07.2004**
(21) Anmeldenummer: 03006403.4
(22) Anmeldetag: 21.03.2003
(51) Int. Cl.: H05K 3/00, H05K 1/14

(54) **Verfahren zur Herstellung von Leiterplatten für ein elektronisches Gerät**

(71) Anmelder: Siemens Schweiz AG, 8047 Zürich (CH)
(72) Erfinder: Allegranza, Patrick, 8004 Zürich (CH)
(74) Vertreter: Kley, Hansjörg

(57) **Zusammenfassung**

Zur kostengünstigen Herstellung eines eine Leiterplatte (1) aufweisenden elektrischen Gerätes wird ein Verfahren mit folgenden Schritten vorgeschlagen:
A Aus einer Leiterplatte (1) wird ein Teil (2) herausgeschnitten,
B Leiterplatte (1) und herausgeschnittenes Teil (2) werden mit elektronischen Bauelementen bestückt;
C das herausgeschnittene Teil (2) wird gegenüber der Leiterplatte (1) versetzt verbunden.

Die Kontaktierung kann dabei z.B. über Flächen (3) mit Durchkontaktierungen oder über Flachbandkabel und einem zusätzlichen mechanischen Befestigungsmittel erfolgen.

## Beschreibung

Die vorliegende Erfindung betrifft ein Verfahren zur Herstellung von Leiterplatten nach dem Oberbegriff des Patentanspruchs 1.

Die vorliegende Erfindung betrifft das Gebiet der Herstellung und Bestückung elektronischer Leiterplatten für sogenannte Hochseriengeräte. Für das Bestehen im Wettbewerb muss vor allem auf eine kostengünstige Herstellung geachtet werden. Deswegen wird für ein Gerät, das z.B. eine Energieversorgungseinheit aufweist, die betreffende Leiterplatte mit den eher grösseren Komponenten von Hand bestückt. Dieser Bestückung erfolgt in sogenannter THT-Technik. Für den Teil, der mit integrierten Bauelementen realisiert werden kann, erfolgt eine Bestückung in sogenannter SMT-Technik. Aufgrund des enormen Preisdruckes erfolgt die Bestückung von Hand in einem sogenannten Billiglohnland und die Bestückung mit den SMD-Teil automatisiert. Für die automatisierte Herstellung ist das Lohnniveau eines Landes von untergeordneter Bedeutung. Aus diesem Grunde werden Leiterplatten unabhängig voneinander entworfen und oft direkt vor Ort für die betreffende Bestückung gefertigt. Dabei wird die kleinere Leiterplatte an geeigneter Stelle auf die grössere Leiterplatte aufgebracht und kontaktiert. Für gewisse Anwendungen ist nachteilig, dass das Layout der beiden Leiterplatte unabhängig voneinander vorgenommen wird und funktionelle Inkompatibilitäten auftreten können.

Der vorliegenden Erfindung liegt daher die Aufgabe zugrunde, ein Verfahren zur Herstellung eines Leiterplatten aufweisenden elektrischen Gerätes anzugeben, das gegenüber den bekannten Verfahren eine weitere Ersparnis ermöglicht und bei dem das Layout der Leiterplatten zentral erfolgen kann.

Diese Aufgabe wird erfindungsgemäss durch das im Patentanspruch 1 angegebene Verfahren gelöst.

Durch die erfindungsgemässen Verfahrensschritte ist einerseits das Leiterplattenmaterial optimal verwendet, da keine unbenutzte Leiterplattenfläche mehr vorhanden ist; andererseits kann das Layout der Leiterbahnen der verschiedenen Leiterplatten zentral vorgenommen werden. Darüber hinaus leistet die Erfindung auch einen Beitrag zum Umweltschutz, da der Verbrauch von Leiterplattenmaterial dadurch reduziert werden kann.

Vorteilhafte Ausgestaltungen der Erfindung sind in weiteren Ansprüchen angegeben.
i) Dadurch, dass
   im Verfahrensschritt A das herausgeschnittene Teil T-förmig ist und im Verfahrensschritt C translatorisch versetzt verbunden wird;
   ist die Handhabung für die Montage besonders einfach und keiner Verwechslungsgefahr ausgesetzt (Patentanspruch 4).

i) Dadurch, dass
   vor dem Verfahrensschritt A der Leiterplatte ein Merkmal hinzugefügt wird, so dass nach Ausführung des Verfahrensschrittes C die Zugehörigkeit von Leiterplatte und herausgeschnittenem Teil festgestellt werden kann;
   wird eine höhere Zuverlässigkeit der erzeugten Geräte erreicht, da sichergestellt ist, dass Leiterplatte und herausgeschnittenes Teil auf dem gleichen Versionsstand der Schaltung beruhen (Patentanspruch 6).

Ein Ausführungsbeispiel der Erfindung wird nachfolgend anhand der Zeichnung näher erläutert. Dabei zeigen:
- Figur 1a: Leiterplatte mit einem T-förmigen herauszuschneidenden Teil;
- Figur 1b: Leiterplatte mit T-förmigen Teil in montiertem Zustand;
- Figur 2a: Leiterplatte mit einem im wesentlichen rechteckförmigen herauszuschneidenden Teil;
- Figur 2b: Leiterplatte mit einem im wesentlichen rechteckförmigen herauszuschneidenden Teil in montiertem Zustand.

Die Erfindung wird anhand der Figuren in zwei Ausführungsformen offenbart. Es zeigen:
Figur 1a:
   Ein im wesentlichen rechteckförmiges herauszuschneidendes Teil 2 aus einer Leiterplatte 1.
Figur 2a:
   T-förmiges herauszuschneidendes Teil 2 aus einer Leiterplatte 1.

Unabhängig von der Form des herauszuschneidenden Teils 2 können auf der Leiterplatte 1 (und damit auch auf dem herauszuschneidenden Teil 2) eine oder mehrere Lagen von Leiterbahnen angeordnet sein. Die Leiterbahnen sind in den Figuren nicht dargestellt. Die herausgeschnittenen Teile 2 werden unabhängig von den verbleibenden Leiterplatten 1 mit Bauelementen in sogenannter THT-Technik bestückt. Das bedeutet, dass die Bauelemente mit dem herausgeschnittenen Teil 2 der Leiterplatte durchkontaktiert werden. Das Teil 2 weist demzufolge Löcher bzw. Bohrungen für die Aufnahme der Kontaktstifte oder Kontaktdrähte auf. Die Bestückung erfolgt meist in Handarbeit. In einem weiteren Arbeitsgang erfolgt der Lötvorgang und damit die elektrischen Kontaktierung mit den Leiterbahnen. Die Leiterplatte 1 wird in automatisierter Weise mit SMD-Bauelementen bestückt. SMT-Technik bedeutet, dass die Bauelemente durch eine Oberflächenkontaktierung mit den Leiterbahnen der Leiterplatte 1 verbunden sind.

Nach erfolgter Bestückung von Leiterplatte 1 und herausgeschnittenem Teil 2 wird das letztere mit der Leiterplatte 1 mechanisch und elektrisch verbunden. Dies kann z.B. mittels THT-Technik oder mittels Schraubtechnik und Flachbandkabeln erfolgen. Die Lage des Teils 2 gegenüber der Leiterplatte ist dabei versetzt:

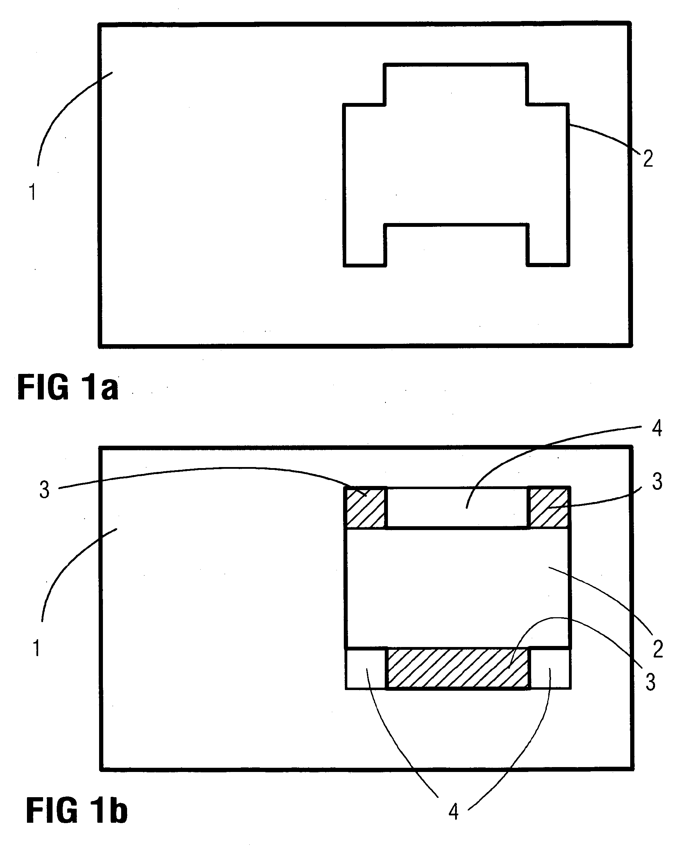

- Fig. 1b:: Das herausgeschnittene Teil 2 ist gegenüber der ursprünglichen Lage um 180° versetzt.

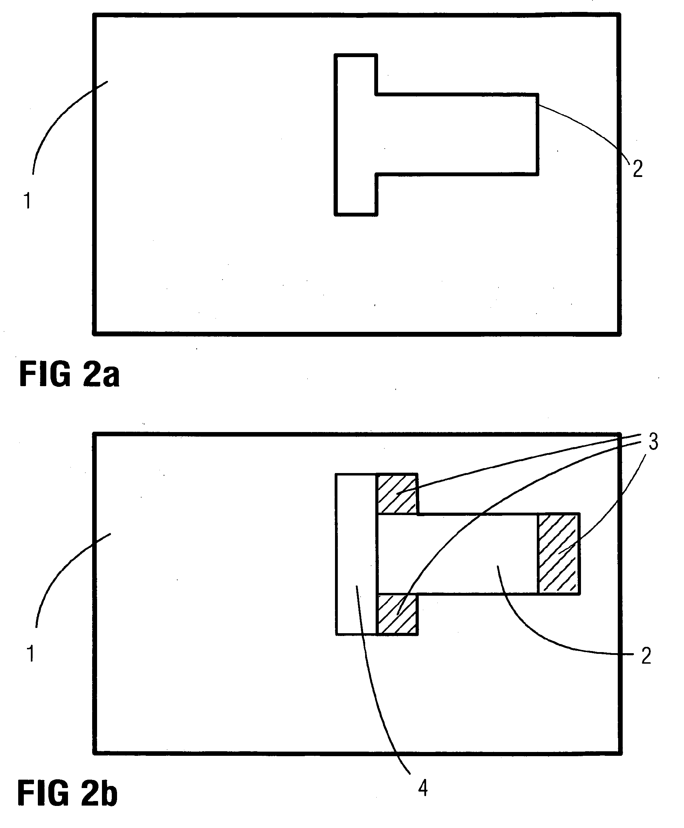

- Fig. 2b:: Das herausgeschnittene Teil 2 ist gegenüber der ursprünglichen Lage translatorisch versetzt, vorzugsweise um die Breite des "T".

Je nach Anwendung kann auch eine nur flächige Kontaktierung 3 vorgesehen werden wie dies in den Figuren 1b und 2b als Prinzip dargestellt ist. Unabhängig von der Kontaktierung bzw. Vebindung von Leiterplatte 1 und herausgeschnittenem Teil 2 entsteht durch die Versetzung ein offenes Stück 4.

Die vorgenannte Bestückung mit in SMD-Technik bzw. THT-Technik kann auch invers erfolgen, das heisst die Leiterplatte 1 wird in THT-Technik bestückt und das herausgeschnittene Teil 2 wird in SMT-Technik bestückt. Dabei ist eingeschlossen, das die jeweilige Technik, d.h. SMT bzw. THT überwiegend angewendet wird.

Alternativ zur vorgenannten Bestückung ist auch eine Mischbestückung möglich. Dies wird angewendet, wenn Leiterplatte 1 und herausgeschnittenes Teil 2 je durch eine spezialisierte Firma bestückt werden; beispielsweise kann das Teil 2 eine Bestückung für eine Stromversorgung aufweisen, gegebenenfalls mit einem Transformator. Dadurch können elektronische Geräte mit modularem Aufbau geschaffen werden, beispielsweise verschiedene Leiterplatten 1 und jeweils ein funktionell identisches Teil 2, z.B. für Stromversorgung oder eine Schnittstellenkarte, die bei einer Gerätefamilie identisch ist.

In einer besonderen Weiterentwicklung der vorliegenden Erfindung kann vorgesehen werden, dass auf der Leiterplatte 1 vor dem Herausschneiden ein Merkmal angebracht wird, um z.B. den versionsstand der betreffenden Leiterplatte 1 zu kennzeichnen. Dieses Merkmal kann alternativ oder kumulativ, beispielhaft folgendermassen ausgeprägt sein:
a) Beschriftung von Leiterplatte 1 und herauszuschneidendem Teil 2;
b) Codierung von Leiterplatte 1 und herauszuschneidendem Teil 2, z.B. mit einem Strichcode;
c) Abstände und Anordnung der Bohrungen/Löcher für die Kontaktierung von Leiterplatte 1 und herausgeschnittenem Teil 2;
d) Form und Dimensionierung von herauszuschneidendem Teil 2.

Auf diese Weise ist sichergestellt, dass nach erfolgter Bestückung nur Leiterplatten 1 und herausgeschnittene Teile 2 zusammen montiert werden können, die auf der gleichen Version des Layouts und damit der Schaltung beruhen.

Die vorstehend erwähnten Formen des herauszuschneidenden Teils sind nur beispielhaft zu verstehen, geometrisch gesehen können weitere Formen - abhängig vom Anwendungsgebiet - vorgesehen werden, Beispiele:
i) Quadrat und rotatorisch um 45° versetzt.
ii) Rechteck und rotatorisch um 90° versetzt.

Die Erfindung leistet einen Beitrag zur kostengünstigen Herstellung von elektronischen Geräten, die in hoher Stückzahl gefertigt werden und Mindestanforderungen bezüglich Zuverlässigkeit und Funktionssicherheit erfüllen müssen. Vorzugsweise wird die Erfindung für Telekommunikationsgeräte angewendet wie z.B. Netzabschlussgeräte oder ADSL-Teilnehmerausrüstungen mit z.B. integriertem Splitter und Modem.

### Liste der verwendeten Bezugszeichen

- 1: Leiterplatte
- 2: herauszuschneidendes Teil, herausgeschnittenes Teil
- 3: Auflagefläche
- 4: offenes Stück nach erfolgter Montage des herausgeschnittenen Teils

### Liste der verwendeten Abkürzungen

- SMD: surface mounted device
- SMT: surface mounted technology
- THT: through hole technology

## Patentansprüche

1. Verfahren zur Herstellung eines eine Leiterplatte (1) aufweisenden elektrischen Gerätes,
**gekennzeichnet durch** die Verfahrensschritte
A aus einer Leiterplatte (1) wird ein Teil (2) herausgeschnitten,
B Leiterplatte (1) und herausgeschnittenes Teil (2) werden mit elektronischen Bauelementen bestückt;
C das herausgeschnittene Teil (2) wird gegenüber der Leiterplatte (1) versetzt verbunden (3).

2. Verfahren nach Anspruch 2,
**dadurch gekennzeichnet, dass**
im Verfahrensschritt B SMD-Bauelemente auf die Leiterplatte (1) und Bauelemente in THT-Technik auf das herausgeschnittene Teil (2) aufgebracht werden.

3. Verfahren nach Anspruch 1,
**dadurch gekennzeichnet, dass**
im Verfahrensschritt B SMD-Bauelemente auf das herausgeschnittene Teil 2 und Bauelemente in THT-Technik auf die Leiterplatte (1) aufgebracht werden.

4. Verfahren nach einem der Ansprüche 1 bis 3,
**dadurch gekennzeichnet, dass**
im Verfahrensschritt A das herausgeschnittene Teil (2) T-förmig ist und im Verfahrensschritt C translatorisch versetzt verbunden wird.

5. Verfahren nach einem der Ansprüche 1 bis 3,
**dadurch gekennzeichnet, dass**
im Verfahrensschritt A das herausgeschnittene Teil (2) rechteckförmig ist und im Verfahrensschritt C rotatorisch versetzt verbunden wird.

6. Verfahren nach einem der Ansprüche 1 bis 5,
**dadurch gekennzeichnet, dass**
vor dem Verfahrensschritt A der Leiterplatte (1) ein Merkmal (5) hinzugefügt wird, so dass nach Ausführung des Verfahrensschrittes C die Zugehörigkeit von Leiterplatte (1) und herausgeschnittenem Teil (2) festgestellt werden kann.

7. Verfahren nach einem der Ansprüche 1 bis 6,
**dadurch gekennzeichnet, dass**
im Verfahrensschritt A mehr als ein Teil (2) herausgeschnitten wird und im Verfahrensschritt C herausgeschnittene, bestückte Teile (2) mit der Leiterplatte (1) verbunden werden.

8. Elektronisches Gerät mit einer durch das Verfahren gemäss einem der Ansprüche 1 bis 7 hergestellten Leiterplatte (1) und herausgeschnittenem Teil (2).

9. Verwendung einer durch das Verfahren gemäss einem der Ansprüche 1 bis 7 hergestellten Leiterplatte (1) und herausgeschnittenen Teils (2) in einem Netzabschlussgerät.
